Europäisches Patentamt

European Patent Office

Office européen des brevets

(19)

(11) Veröffentlichungsnummer : **0 039 917
B1**

(12)

# EUROPÄISCHE PATENTSCHRIFT

(45) Veröffentlichungstag der Patentschrift :
20.02.85

(21) Anmeldenummer : 81103495.8

(22) Anmeldetag : 07.05.81

(51) Int. Cl.⁴ : **G 05 B 5/01, H 02 P 9/10,
H 02 J 3/24**

(54) **Schaltungsanordnung zur Bedämpfung von Leistungspendelungen in Netzen.**

(30) Priorität : 14.05.80 DE 3018464

(43) Veröffentlichungstag der Anmeldung :
18.11.81 Patentblatt 81/46

(45) Bekanntmachung des Hinweises auf die Patenterteilung : 20.02.85 Patentblatt 85/08

(84) Benannte Vertragsstaaten :
BE CH FR GB LI NL SE

(56) Entgegenhaltungen :
DE-B- 1 541 949
DE-B- 2 651 813
DE-C- 1 149 808
US-A- 3 808 486

(73) Patentinhaber : **Siemens Aktiengesellschaft
Berlin und München Wittelsbacherplatz 2
D-8000 München 2 (DE)**

(72) Erfinder : **Fork, Kurt, Dr.
Rosenbach 33
D-8524 Neunkirchen (DE)**
Erfinder : **Günther, Ott, Dipl.-Ing.
Friedrich-Bauer-Strasse 1
D-8520 Erlangen (DE)**

## Beschreibung

Die Erfindung betrifft eine Schaltungsanordnung zur Bedämpfung von Leistungspendelungen in Netzen nach dem Oberbegriff des Anspruches 1.

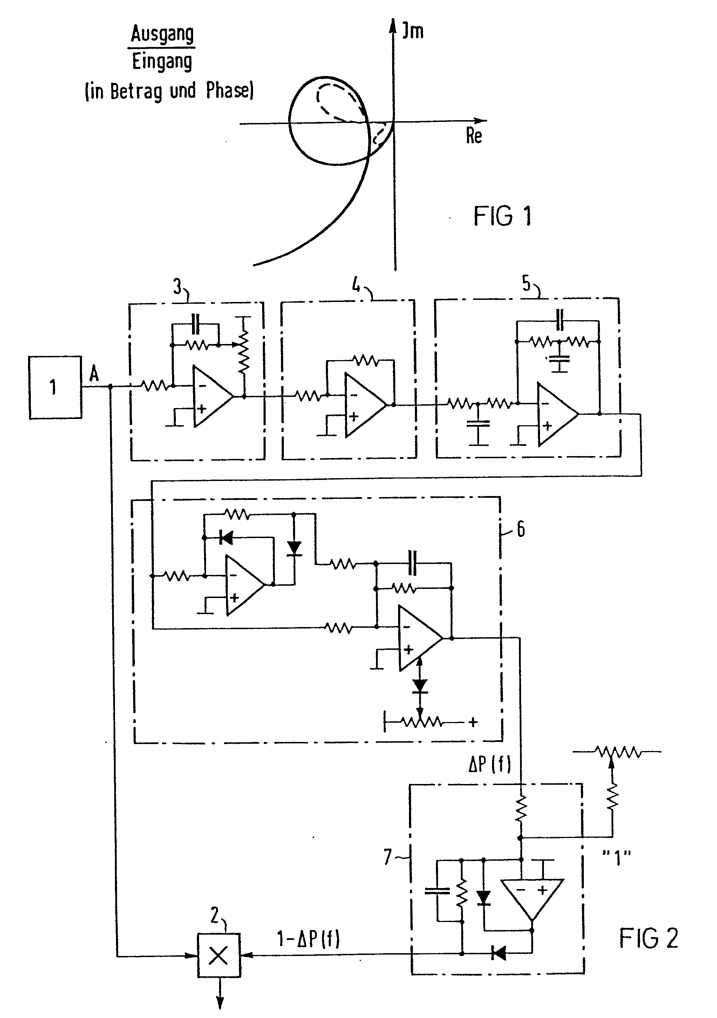

Bei einer solchen Schaltungsanordnung nach der europäischen Patentanmeldung Nr. 79 10 4601.4 werden ausgangsseitig Wechsel-Ausgangssignale auf Erregeranordnungen von spannungsgeregelten Synchronmaschinen gegeben, die zu einer in Fig. 1 ausgezogen dargestellten Ortskurve der Pendelfrequenzen führen. Man hat festgestellt, daß dabei niedrige Pendelfrequenzen nicht immer ausreichend gedämpft werden können. Zur Erhöhung der Dämpfung bei niedrigen Pendelfrequenzen hat man deshalb die Verstärkung der Schaltungsanordnung nach der europäischen Patentanmeldung Nr. 79 10 4601.4 vermindert, was jedoch für die Dämpfung bei höheren Pendelfrequenzen von Nachteil gewesen ist.

Der Erfindung liegt zur Beseitigung der genannten Nachteile die Aufgabe zugrunde, einen nach Betrag und Grenzfrequenz einstellbaren Teil des in einem Frequenzbereich auftretenden, die Erregeranordnung beeinflussenden Wechsel-Ausgangssignals zu unterdrücken und die im übrigen Frequenzbereich auftretenden Wechsel-Ausgangssignale hinsichtlich ihres Frequenzganges unverändert auf die Erregeranordnung wirken zu lassen.

Die Lösung der gestellten Aufgabe gelingt durch die Maßnahmen nach dem Kennzeichen des Anspruchs 1, wobei je nach Art und Größe des Frequenzbereiches als Filter ein Tief-, Hoch- oder Bandpaß vorgesehen wird. Für den Fall, daß eine ungenügende Dämpfung von Pendeldämpfungsgeräten bei hohen Frequenzen beseitigt werden soll, ist an Stelle eines Tiefpasses ein entsprechend ausgelegter Hochpaß vorzusehen. Dies ist der Fall, wenn Pendelfrequenzen über 5 Hz, wie sie bei Torsionsschwingungen auftreten, ohne Phasendrehung ausgefiltert werden sollen. Bei anderen kritischen Frequenzbereichen kann auch stattdessen ein breiterer Bandpaß vorgesehen werden.

Eine vorteilhafte Ausgestaltung der Erfindung für die Beeinflussung des Wechsel-Ausgangssignals einer solchen Schaltungsanordnung zur Bedämpfung von Leistungspendelungen in Netzen für die phasenunabhängige Verringerung des Wechsel-Ausgangssignals bei niedrigen Pendelfrequenzen mit einem in Fig. 1 gestrichelten Anfangsverlauf der Ortskurve ist in Fig. 2 der Zeichnung vereinfacht dargestellt und nachfolgend erläutert.

Eine nachfolgend als Pendeldämpfungsgerät 1 bezeichnete Schaltungsanordnung mit einer ausgezogenen Ortskurve nach Fig. 1 gibt ausgangsseitig ein pendeldämpfendes Ausgangs-Wechselsignal A ab für die Beeinflussung einer nicht dargestellten spannungsgeregelten Erregeranordnung für eine ebenfalls nicht dargestellte Synchronmaschine. Damit das Pendeldämpfungsgerät 1 aufgrund seiner Ortskurve auch bei Pendelfrequenzen um 0,2 Hz eine optimale Dämpfung herbeiführt, ist es erforderlich, daß ein Wechselsignal ohne Beeinflussung der Phasenlage verringert wird im Sinne des gestrichelt dargestellten Anfangsverlaufes seiner Ortskurve nach Fig. 1.

Das sinusförmige Ausgangs-Wechselsignal A des Pendeldämpfungsgerätes 1 wird hierzu unmittelbar einem ersten Eingang eines üblichen Multiplizierers 2 und außerdem dem Eingang einer zur Anpassung dienenden Verstärkeranordnung 3, 4 zugeführt. Der erste Verstärker 3 ist ein invertierender Zeitverzug 1. Ordnung und der zweite Verstärker 4 ein invertierender Operationsverstärker. Das Ausgangssignal des Verstärkers 4 wird einem Tiefpaß 5 zugeführt, dessen Grenzfrequenz $f_G$ kleiner als die zu unterdrückende Pendelfrequenz, im Beispiel also kleiner als 0,2 Hz gewählt ist, so daß im konkreten Fall Pendelfrequenzen bis zu etwa 0,25 Hz stark vermindert und Pendelfrequenzen von 0,4 Hz und mehr praktisch unvermindert auf eine glättende, gleichrichtende Begrenzungsschaltung 6 gelangen, an deren Ausgang eine auf einen bestimmten Wert begrenzte, geglättete, gleichgerichtete elektrische Größe $\Delta P(f)$ auftritt, die mit einem gesondert gebildeten Einheitssignal « 1 », das entsprechend dem Maximalwert von A bemessen ist, in einem Differenzbildner 7 verglichen und die Differenz $1-\Delta P(f)$ beider Gleichgrößen auf den zweiten Eingang des Multiplizierers 2 gegeben wird.

Die Bemessung der Teile 3 bis 6 ist so ausgelegt, daß die elektrische Größe am Ausgang der Schaltung 6 den Betrag des Einheitssignals « 1 » nicht überschreitet, so daß als Differenz am Ausgang des Differenzbildners 7 nur Werte von Null bis zum Einheitssignal « 1 » auftreten können. Durch die Gleichrichtung und Glättung wird eine nachteilige Phasendrehung des Ausgangs-Wechselsignals A des Pendeldämpfungsgerätes 1 mit Sicherheit auch bei niedrigen Pendelfrequenzen vermieden. Unterhalb der Grenzfrequenz $f_G$ ist der als Multiplikationsfaktor benutzte Differenzbetrag $1-\Delta P(f)$ Null oder nahezu Null, oberhalb von 0,4 Hz eins oder nahezu eins.

## Ansprüche

1. Schaltungsanordnung zur Bedämpfung von Leistungspendelungen in Netzen durch von Leistungsänderungen abgeleitete Signale, deren für die Beeinflussung einer spannungsgeregelten Erregeranordnung mindestens einer Synchronmaschine benutztes Wechsel-Ausgangssignal zur Bedämpfung der Leistungspendelungen sich in seiner Phasenlage in einem wählbaren Frequenzbereich mit steigender Pendelfrequenz in mathematisch positivem Sinne ändert, dadurch gekennzeichnet, daß aus dem Wechsel-Ausgangssignal (A) des Pendeldämpfungsgerätes (1) und einer aus dem Wechsel-Ausgangssignal (A) abgeleiteten Korrekturgröße (1-$\triangle$P(f)) in einem Multiplizierer (2) das auf die Erregeranordnung wirkende Produkt gebildet wird und zur Ableitung der Korrekturgröße das Wechsel-Ausgangssignal (A) angepaßt verstärkt über einen auf den zu unterschreitenden Grenzfrequenzbereich abgestimmten Filter (5) einer gleichrichtenden glättenden Begrenzerschaltung (6) zugeführt ist, deren auf höchstens den Maximalwert des Wechsel-Ausgangssignals (A) begrenzte Ausgangsgröße ($\triangle$P(f)) in einem Differenzbildner (7) von einem dem Maximalwert des Wechsel-Ausgangssignals (A) entsprechenden Einheitssignal (« 1 ») subtrahiert und von seinem Ausgang die Differenz als Korrekturgröße auf den Multiplizierer (2) gegeben ist.

2. Schaltungsanordnung nach Anspruch 1, dadurch gekennzeichnet, daß zur Verstärkung des Wechsel-Ausgangssignals (A) die Reihenschaltung eines invertierenden Zeitverzugs 1. Ordnung (3) mit einem invertierenden Operationsverstärker (4) vorgesehen ist.

## Claims

1. A circuit arrangement for damping power oscillations in mains power supply systems by means of signals derived from changes in the power loading, to produce an alternating current output signal which is used to influence a voltage regulated exciter arrangement of at least one synchronous machine changing in phase in a mathematically positive direction in a selectable frequency range with increasing oscillation frequency in order to damp the power oscillations, characterised in that the alternating current output signal (A) of the oscillation damping device (1) and a correction value (1-$\triangle$P(f)) are used in a multiplier (2) to derive from the alternating current output signal (A) the product which acts upon the exciter arrangement, and to obtain the correcting value, the alternating current output signal (A) is amplified and fed via a filter (5) tuned to the cut-off frequency range which is to be emphasized, to a rectifying, smoothing limiter circuit (6), whose output value ($\triangle$P(f)), which is limited at the maximum to the maximum value of the alternating current output signal (A), is subtracted in a difference forming device (7) from a standard signal (« 1 ») which corresponds to the maximum value of the alternating current output signal (A), and the output of the difference forming device if fed as a correction value to the multiplier (2).

2. A circuit arrangement as claimed in Claim 1, characterised in that the series arrangement of an inverting time delay of the first order (3) with an inverting operational amplifier (4) is provided for the amplification of the alternating current output signal (A).

## Revendications

1. Montage pour amortir les oscillations de la puissance dans des réseaux par des signaux dérivés de variations de la puissance, dont le signal alternatif de sortie, utilisé pour influencer le dispositif d'excitation, régulé en tension, d'au moins une machine synchrone, change, du point de vue de sa phase dans une plage de fréquences susceptible d'être choisie, dans un sens mathématiquement positif pour une fréquence d'oscillations croissante, caractérisé par le fait qu'à partir du signal alternatif de sortie (A) de l'appareil d'amortissement des oscillations (1) et d'une grandeur de correction (1-$\triangle$P(f)) dérivée du signal alternatif de sortie (A), on forme, dans un multiplicateur (2), le produit agissant sur le dispositif d'excitation et que pour dériver la grandeur de correction, le signal alternatif de sortie (A), amplifié avec adaptation, est appliqué, par l'intermédiaire d'un filtre (5) réglé sur la plage de fréquences limites à ne pas atteindre, à un circuit de limitation (6) redresseur et lissant, dont la grandeur de sortie ($\triangle$P(f)) limitée au maximum à la valeur maximale du signal alternatif de sortie (A), est soustraite dans un différenciateur (7) d'un signal unitaire (« 1 ») qui correspond à la valeur maximale du signal alternatif de sortie (A), la différence étant appliquée, par la sortie du différenciateur, au multiplicateur, en tant que grandeur de correction.

2. Montage selon la revendication 1, caractérisé par le fait que pour amplifier le signal alternatif de sortie (A), il est prévu le circuit série d'un circuit à retard inverseur (3) du premier ordre avec un amplificateur opérationnel inverseur (4).

Ausgang
────────
Eingang
(in Betrag und Phase)

FIG 1

$\Delta P(f)$

"1"

$1 - \Delta P(f)$

FIG 2